Europäisches Patentamt

European Patent Office

Office européen des brevets

(11) Publication number: **0 490 527 A1**

## EUROPEAN PATENT APPLICATION

(21) Application number: **91310951.8**

(22) Date of filing: **27.11.91**

(51) Int. Cl.5: **C30B 11/00**, C22C 19/05, C30B 29/52

(30) Priority: **14.12.90 US 627706**

(43) Date of publication of application:
**17.06.92 Bulletin 92/25**

(84) Designated Contracting States:
**CH DE FR GB IT LI NL SE**

(71) Applicant: **GENERAL ELECTRIC COMPANY**
**1 River Road**
**Schenectady, NY 12345(US)**

(72) Inventor: **Peterson, Lance Gordon**
**RD 2 Peacable Street**
**Galway, New York 12074(US)**
Inventor: **Vasatis, Ioannis Platon**
**18 Hancock Way**
**Clifton Park, New York 12065(US)**

(74) Representative: **Pratt, Richard Wilson et al**
**London Patent Operation G.E. Technical**
**Services Co. Inc. Essex House 12/13 Essex**
**Street**
**London WC2R 3AA(GB)**

(54) **Nickel-base superalloys and components thereof.**

(57) Industrial gas turbine engine single crystal blades of nickel-base superalloy containing 1-3% rhenium have superior mechanical properties in the normal 1600-1800° F engine operating temperature range.

EP 0 490 527 A1

## Field of the Invention

The present invention relates generally to superalloys and is more particularly concerned with novel rhenium-containing nickel-base alloys, and with new single crystal gas turbine blades of those alloys especially suited to use in industrial gas turbine engines because of their unique combination of mechanical and corrosion resistance properties under typical operating conditions.

## Background of the Invention

It is well known that gas turbine engine buckets in single crystal form hold important mechancial properties advantages over those of equiaxed microstructure. For some time, such parts have been used by major suppliers of military aircraft jet engines and commercial aircraft application of this technology is now being pursued.

This has led to attempts to replace buckets of equiaxed microstructure with a single crystal type. This would enable elimination of elements added solely for the purpose of forming grain boundry strengthening phases thereby reducing the volume fraction of brittle phases and altering the way elements partition to form the alloy's strengthening phase, gamma prime.

Lack of predictability concerning the important properties of addition, reduction and elimination of alloy elements makes translation of aircraft engine single crystal bucket development experience of little value in this endeavor.

## Summary of the Invention

In making this invention, we discovered that under certain conditions a relatively small amount of rhenium will dramatically improve mechanical properties of a single crystal alloy article. Further, we found that the amount of rhenium is critical in that a small amount more than the optimum diminishes those properties to a marked degree.

We have also discovered that reversing the ratio of aluminum to titanium in these alloys under some conditions results in a significant improvement in mechanical properties of the ultimate article. Finally, we have discovered that the above improving effect of rhenium is independent of this aluminum-titantium ratio variation and that the rupture life of these alloys peaks at about 2% rhenium.

Briefly described, the novel alloy of this invention is one of nickel base consisting essentially of about 1-3% rhenium, about 14% chromium, about 9.5% cobalt, about 3.8% tungsten, about 2% tantalum, about 1.5% molybdenum, about 0.05% carbon, about 0.004% boron and, respectively, from about 3-4.8% aluminum and from about 4.8% to about 3% titanium, balance nickel.

## Detailed Description of the Invention

In accordance with the preferred practice of this invention the composition of a nickel-base single crystal superalloy is modified to obtain a significant improvement in mechanical properties, particularly in the normal 1600 - 1800° F operating temperature range of industrial gas turbine engines. For this purpose, the amount of carbon and the amount of boron are both substantially reduced and the amount of tantalum is reduced to significant extent. Thus, the nickel-base alloy presently in general use in land-based and marine gas turbine engines of a wide variety is changed in recognition of the opportunity offered by the single crystal form, grain bound any strengthening effects being eliminated to a large degree as the carbon is cut by one half (0.1% to 0.05%) boron is cut by two thirds (0.012% to 0.004%) and the tantalum is also reduced (2.8% to 2.0%). Still further, the original aluminum-titanium ratio of 3 to 4.8% is retained in certain of the alloys of this invention while it is reversed in others.

In practicing this invention, these new alloys are cast into single crystal turbine blades in the usual practice of single crystal casting technique known and generally practiced in the art, preferably the withdrawal process. If desired, the cast components may then be treated for homogenization purposes and to precipitation heat treatment to assure precipitation of all gamma prime phase from solution.

Those skilled in the art will gain a further and better understanding of this invention from the following illustrative, but not limiting, examples of the practice of this invention as it has been experimentally conducted.

EXAMPLE I

A test piece casting was provided by preparing a melt of alloy of the following composition:

| | |
|---|---|
| Chromium | 14% |
| Cobalt | 9.5% |
| Molybdenum | 1.5% |
| Tungsten | 3.8% |
| Aluminum | 3% |
| Titanium | 4.8% |
| Tantalum | 2% |
| Carbon | 0.05% |
| Boron | 0.004% |
| Nickel | Balance |

Using the withdrawal technique for production of single crystal castings, a test piece was produced in standard form for mechanical properties evaluation. The casting was heat treated at 22 - 28° F for two hours and cooled to room temperature at the rate of 104° F per minute and thereafter was heated to 1472° F, maintained for 24 hours, and then furnace cooled to room temperature. On test the rupture life of this casting was 30 hours at 1800° under 27 thousand pounds per square inch (ksi) stress.

EXAMPLE II

Another melt was prepared of the alloy of Example I with, however, an addition of 1% rhenium and casting was produced as described in Example I and heat treated and tested as also described above, with the result that the rupture life under the 1800° F-2700 ksi stress conditions proved to be 60 hours.

EXAMPLE III

An alloy the same as that of Examples I and II, except that it contained 2% rhenium, was melted and cast and the casting was heat treated and tested as described above, with the result that the rupture life proved to be 150 hours under the 1800° -2700 ksi stress conditions.

EXAMPLE IV

In another experiment like that of Example I, the following composition was prepared as a melt:

| | |
|---|---|
| Chromium | 14% |
| Cobalt | 9.5% |
| Molybdenum | 1.5% |
| Tungsten | 3.8% |
| Aluminum | 4.8% |
| Titanium | 3% |
| Tantalum | 2% |
| Carbon | 0.05% |
| Boron | 0.004% |
| Nickel | Balance |

The resulting casting, heat treated and tested as described in the foregoing examples, proved to have a rupture life at 1800° F and 27 ksi stress of nearly 150 hours.

EXAMPLE V

A melt of the alloy of Example IV, except that it contained 2% rhenium, was used in the production of the single crystal test piece casting which was heat treated and tested as described in Example IV, with the result that it proved to have a rupture life in excess of 275 hours.

EXAMPLE VI

An alloy similar to that of Examples IV and V, but containing 1.5% titanium instead of 3%, and containing 3% rhenium instead of 2%, was prepared as a melt and used to produce a single crystal test casting. The casting was heat treated as described in the foregoing examples and tested under the same conditions, with the result that it proved to have a rupture life of 160 hours.

In the specification and in the appended claims, wherever percentages, proportions or ratios are stated, reference is to the weight basis unless otherwise specifically noted.

**Claims**

1.  An industrial gas turbine hot stage component in a form of a nickel-base alloy single crystal consisting essentially of about 1-3% rhenium, about 14% chromium, about 9.5% cobalt, about 3.8% tungsten, about 2% tantalum, 1.5% molybdenum, about 0.05% carbon, about 0.004% boron and, respectively, from about 3 to 4.8% aluminum from about 4.8% to about 3% titanium, balance nickel.

2.  The single crystal article of Claim 1 in which the alloy consists essentially of about 2% rhenium, about 14% chromium, about 9.5% cobalt, about 1.5% molybdenum, about 3.8% tungsten, about 4.8% aluminum, about 3% titanium, about 2% tantalum, about 0.05% carbon, about 0.004% boron, balance nickel.

3.  The single crystal article of Claim 1 in which the alloy of about 14% chromium, about 9.5% cobalt, about 5% molybdenum, about 3.8% tungsten, about 2% rhenium, about 3% aluminum, about 4.8% titanium, about 2% tantalum, about 0.05% carbon, about 0.004% boron, balance nickel.

4.  The single crystal article of Claim 1 in which the alloy consists essentially of about 14% chromium, about 9.5% cobalt, about 5% molybdenum, about 3.8% tungsten, about 3% rhenium, about 3% aluminum, about 4.8% titanium, about 2% tantalum, about 0.05% carbon, about 0.004% boron.

5.  A nickel-base superalloy having special utility in the production of single crystal gas turbine engine blades consisting essentially of about 1-3% rhenium, about 14% chromium, about 9.5% cobalt, about 3.8% tungsten, about 2% tantalum, about 0.05% carbon, about 0.004% boron and, respectively, from about 3 to 4.8% aluminum and from about 4.8% to 3% titanium, balance nickel.

6.  An alloy of Claim 5 consisting essentially of about 2% rhenium, about 14% chromium, about 9.5% cobalt, about 3.8% tungsten, about 2% tantalum, about 1.5% molybdenum, about 0.05% carbon, about 0.004% baron, about 4.8% aluminum, about 3% titanium, balance nickel.

7.  An alloy of Claim 1 consisting essentially of about 14% chromium, about 9.5% cobalt, about 3.8% tungsten, about 2% tantalum, about 2% rhenium, about 1.5% molybdenum, about 0.05% carbon, about 0.004% boron, about 3% aluminum, about 4.8% titanium, balance nickel.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 240 451 (UNITED TECHNOLOGIES CORPORATION) * claims 1,2 * --- | 1,5 | C30B11/00 C22C19/05 C30B29/52 |
| A | EP-A-0 225 837 (UNITED TECHNOLOGIES CORPORATION) * claims 1,2; table 1 * --- | 1,5 | |
| A | EP-A-0 076 360 (GENERAL ELECTRIC COMPANY) * claims 1,2; table 1 * --- | 1,5 | |
| A | EP-A-0 398 264 (MITSUBISHI METAL CORPORATION) * claims 1,2; tables 1,3 * --- | 1,5 | |
| A | GB-A-2 153 848 (UNITED TECHNOLOGIES CORPORATION) ----- | | |
| | | | **TECHNICAL FIELDS SEARCHED (Int. Cl.5)** |
| | | | C30B C22C |

The present search report has been drawn up for all claims

| Place of search | Date of completion of the search | Examiner |
|---|---|---|
| THE HAGUE | 27 FEBRUARY 1992 | GREGG N. R. |

EPO FORM 1503 03.82 (P0401)